# EUROPEAN PATENT APPLICATION

(11) **EP 4 525 227 A1**
(43) Date of publication of application: **19.03.2025**
(21) Application number: 23802510.0
(22) Date of filing: 24.03.2023
(51) Int. Cl.: H01S 5/40

(54) **TUNABLE LASER AND OPTICAL SEMICONDUCTOR ELEMENT**

(30) Priority: 07.05.2022 CN 202210492198
(71) Applicant: Innolight Technology (Suzhou) Ltd., Suzhou, Jiangsu 215000 (CN)
(72) Inventor: LI, Chenlei, Suzhou, Jiangsu 215000 (CN); ZHENG, Xuezhe, Suzhou, Jiangsu 215000 (CN)
(74) Representative: Becker, Eberhard
(86) International application number: PCT/CN2023/083801
(87) International publication number: WO 2023/216734

(57) **Abstract**

A tunable laser (100), comprising: a channel selection assembly (20), a plurality of optical amplifiers (10), a micro-ring filtering assembly (30) and a reflection assembly (40). The micro-ring filtering assembly (30) is coupled to the reflection assembly (40); working wavelength ranges of the optical amplifiers (10) are different; the channel selection assembly (20) is used for selecting any optical amplifier (10) to input a gain optical signal to the micro-ring filtering assembly (30); the micro-ring filtering assembly (30) is used for filtering the gain optical signal under a vernier caliper effect to obtain filtered optical signals, and then inputting same into the reflection assembly (40); the reflection assembly (40) is used for outputting some of the filtered optical signal outwards, and reflecting, after the remaining optical signals pass through the micro-ring filtering assembly (30), the remaining optical signals to an optical amplifier (10) currently selected by the channel selection assembly (20). Therefore, a wavelength range of laser tuning is large.

## Description

This application claims the priority benefit of China application filed on May 7, 2022, no. 202210492198.4, with the title of invention being "TUNABLE LASER AND OPTICAL SEMICONDUCTOR ELEMENT". The entirety of the above-mentioned patent applications is hereby incorporated by reference herein and made a part of this specification.

### Technical Field

The present disclosure relates to the technical field of laser, and in particular to a tunable laser and an optical semiconductor element.

### Related Art

As advancements in laser technology continue to progress, silicon photonic chips have garnered increasing attention in fields such as data centers and optical interconnects due to their advantages of compact size and ease of integration. These chips are widely regarded as a key technology for next-generation networks. In this context, expanding the laser tuning wavelength range of silicon photonic chips has become a focal point of research, with the aim of enabling these chips to scan across a broader free spectral range.

In the relevant technology, the tunable laser includes a gain chip and a dual micro-ring resonator cavity, wherein the gain chip is coupled to the dual micro-ring resonator cavity. Within the gain bandwidth of the gain chip, laser tuning of the tunable laser is achieved through the vernier caliper effect of the dual micro-ring resonator cavity.

However, due to the limited gain bandwidth of individual gain chips, the tunable range of wavelengths for laser tuning in tunable lasers is restricted, thereby precluding further expansion of the free spectral range during scanning of silicon photonic chips.

### SUMMARY OF INVENTION

### Technical Problem

In light of the foregoing, it is necessary to provide a tunable laser and an optical semiconductor element to address the aforementioned issue of limited wavelength tuning range in laser tuning.

### Technical Solution to Problem

In a first aspect, the present disclosure provides a tunable laser, which includes a channel selection assembly, a plurality of optical amplifiers, a micro-ring filtering assembly and a reflection assembly. The micro-ring filtering assembly is coupled to the reflection assembly, and operation wavelength ranges of the respective optical amplifiers are different.

The channel selection assembly is configured to select any of the optical amplifiers to input a gain optical signal to the micro-ring filtering assembly.

The micro-ring filtering assembly is configured to filter the gain optical signal under the vernier caliper effect to obtain a filtered optical signal and then input the filtered optical signal into the reflection assembly.

The reflection assembly is configured to output a part of the optical signal in the filtered optical signal outward, and reflect, after the remaining optical signals pass through the micro-ring filtering assembly, the remaining optical signals to an optical amplifier currently selected by the channel selection assembly.

In an embodiment, the channel selection assembly includes a switch controller, and the switch controller is respectively connected to the plurality of optical amplifiers; the number of the micro-ring filtering assembly is multiple, and the plurality of micro-ring filtering assemblies are respectively coupled to the plurality of optical amplifiers.

The switch controller is configured to control the conduction of any optical amplifier and input a driving electrical signal to the conducted optical amplifier.

The optical amplifier is configured to output a gain optical signal to a micro-ring filtering assembly correspondingly coupled thereto under the drive of the driving electrical signal.

In an embodiment, the channel selection assembly includes a first optical switch. The first optical switch includes two first input terminals and a first output terminal. The two first input terminals of the first optical switch terminals are respectively connected to two of the optical amplifiers, and the first output terminal is connected to the micro-ring filtering assembly.

The first optical switch is configured to control one of the optical amplifiers to input a gain optical signal to the micro-ring filtering assembly.

In an embodiment, the tunable laser further includes a first phase shifter, the first phase shifter is connected to the optical amplifier and coupled to the micro-ring filtering assembly; each of the optical amplifiers includes a semiconductor optical amplifier with high-reflectivity surface.

The reflection assembly is configured to reflect a part of optical signal in the filtered optical signal to the high-reflectivity surface of the semiconductor optical amplifier through the micro-ring filtering assembly, and together with the semiconductor optical amplifier form a characteristic resonant cavity.

The first phase shifter is configured to adjust the resonant wavelength of the characteristic resonant cavity to be the same as the resonant wavelength of the micro-ring filter.

In an embodiment, the micro-ring filtering assembly includes a first micro-ring resonant cavity and a second micro-ring resonant cavity, and the first micro-ring resonant cavity and the second micro-ring resonant cavity have different dimensions and the same resonant wavelength. The first micro-ring resonant cavity is coupled to the semiconductor optical amplifier and the second micro-ring resonant cavity respectively, and the second micro-ring resonant cavity is coupled to the reflection assembly.

The first micro-ring resonant cavity and the second micro-ring resonant cavity jointly produce a vernier caliper effect to filter the gain optical signal.

The first phase shifter is configured to adjust the resonant wavelength of the characteristic resonant cavity to be the same as the resonant wavelengths of the first micro-ring resonant cavity and the second micro-ring resonant cavity.

In an embodiment, the first micro-ring resonant cavity includes a first micro-ring and a second phase shifter connected to the first micro-ring, the second micro-ring resonant cavity includes a second micro-ring and a third phase shifter connected to the second micro-ring, and the first micro-ring and the second micro-ring having different dimensions.

The second phase shifter is configured to adjust the resonant wavelength of the first micro-ring.

The third phase shifter is configured to adjust the resonant wavelength of the second micro-ring to be the same as the resonant wavelength of the first micro-ring.

In an embodiment, the reflection assembly includes a mutually coupled optical reflector and a first optical coupler. The optical reflector is coupled to the micro-ring filtering assembly. The first optical coupler includes a second output terminal and a third output terminal, and the first optical coupler is coupled to the micro-ring filtering assembly.

The optical reflector is configured to input the filtered optical signal to the first optical coupler.

The first optical coupler is configured to output a part of optical signal in the filtered optical signal outward through the second output terminal, and reflect the remaining optical signal in the filtered optical signal into the micro-ring filtering assembly through the third output terminal.

In an embodiment, each of the optical amplifiers includes a semiconductor optical amplifier with a high-reflectivity surface, and the reflection assembly and the high-reflectivity surface of the semiconductor optical amplifier together form a characteristic resonant cavity.

The coupling coefficient of the first optical coupler is a predetermined proportional threshold; wherein said proportional threshold is established in correlation with the loss of the characteristic resonant cavity and the intensity of reflected light from the characteristic resonant cavity on the semiconductor optical amplifier.

In an embodiment, the first optical coupler includes a second optical switch having two adjustment arms.

The second optical switch is configured to adjust the coupling coefficient of the first optical coupler by adjusting the light splitting ratio of the two adjustment arms.

In an embodiment, the integration method of the tunable laser includes but is not limited to one of heterogeneous integration or hybrid integration.

In the above tunable laser, any optical amplifier is selected through the channel selection assembly to input the gain optical signal to the micro-ring filtering assembly. The gain optical signal is filtered by the micro-ring filtering assembly and input to the reflection assembly. The reflection assembly outputs a part of the optical signal outward, and sequentially reflects the remaining optical signals into the optical amplifier through the micro-ring filtering assembly and the channel selection assembly. The reflection assembly and the optical amplifier together form a resonant cavity to achieve tuning of the laser. In the above structure, the plurality of optical amplifiers respectively correspond to different gain wavelength ranges. The utilization of a channel selection assembly enables the alternating use of the plurality of optical amplifiers, thereby effectively expanding the wavelength range of laser tuning in a tunable laser.

In a second aspect, the present disclosure further provides an optical semiconductor element, on which the above-mentioned tunable laser is integrated.

### Beneficial Effects

In the above-mentioned optical semiconductor, through the arrangement of the above-mentioned tunable laser, the effect of expanding the wavelength range of laser tuning may be achieved.

### BRIEF DESCRIPTION OF THE DRAWINGS

To provide a clearer explanation of the technical solutions in embodiments of the present disclosure or in conventional technology, a brief introduction to the drawings required in the description of the embodiments or conventional technology will be provided below. It is evident that the drawings described below are merely some embodiments of the present disclosure. Those skilled in the art may obtain other drawings based on these drawings without exerting creative effort.
FIG. 1 is a schematic diagram of a tunable laser module according to an embodiment.
FIG. 2 is a schematic structural diagram of a tunable laser according to an embodiment.
FIG. 3 is a schematic diagram of the reflection spectrum of an optical amplifier utilizing a micro-ring filtering assembly in an embodiment.
FIG. 4 is a schematic structural diagram of a tunable laser according to another embodiment.

### DESCRIPTION OF EMBODIMENTS

In order to make the above objects, features and advantages of the present disclosure more obvious and understandable, specific embodiments of the present disclosure will be described in detail below with reference to the accompanying drawings. In the following description, numerous specific details are set forth in order to provide a thorough understanding of the disclosure. However, the present disclosure can be implemented in many other ways than those described here. Those skilled in the art can make similar improvements without departing from the connotation of the present disclosure. Therefore, the present disclosure is not limited to the specific embodiments disclosed below.

In the description of the present disclosure, it should be understood that the terms "first" and "second" are used solely for descriptive purposes and should not be construed as indicating or implying relative importance or tacitly specifying the number of technical features referred to. Accordingly, features qualified by "first" and "second" may explicitly or implicitly include at least one such feature. In the description of the present disclosure, "several" means one or more, "multiple" means at least two, for example, two, three, etc., unless otherwise explicitly and specifically limited. The meanings of "multiple groups," "multiple channels," and "multiple beams" follow the same principle and will not be elaborated upon further herein.

In the present disclosure, unless explicitly stipulated or limited otherwise, terms such as "install," "connect," "join," "fix," and the like shall be construed broadly. For instance, these terms may denote a fixed connection or a detachable connection, or an integral formation; they may signify a mechanical connection or an electrical connection; they may indicate a direct connection or an indirect connection through an intermediary medium. These terms may also refer to internal communication between two elements or the interactive relationship between two elements. Unless explicitly limited otherwise, those skilled in the art should interpret the specific meanings of the aforementioned terms in the context of the present disclosure based on the particular circumstances.

It should be noted that when a component is described as "fixed to" or "mounted on" another component, it may be directly on the other component or there may be an intervening component. When a component is considered to be "connected to" another component, it may be directly connected to the other component or there may be intervening components present.

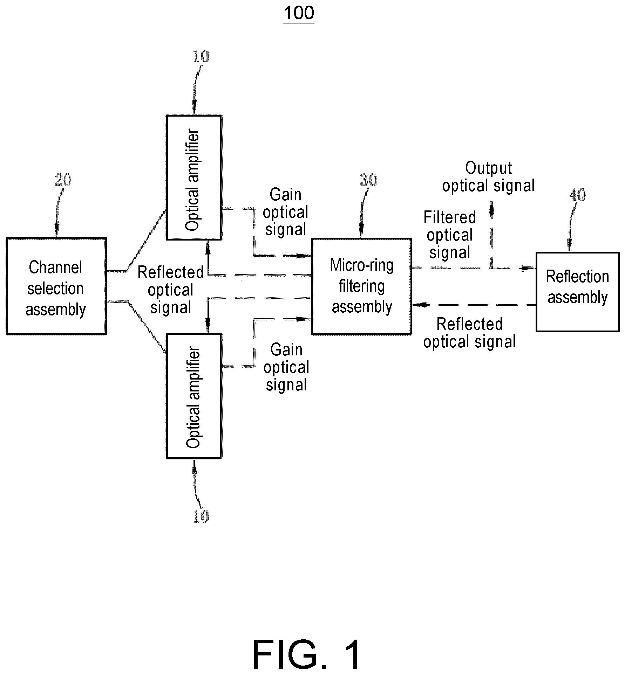

Referring to FIG. 1, the present disclosure provides a tunable laser 100, which includes a plurality of optical amplifiers 10, a channel selection assembly 20, a micro-ring filtering assembly 30 and a reflection assembly 40.

The plurality of optical amplifiers 10 with different operation wavelength ranges are connected in parallel to the channel selection assembly 20, the channel selection assembly 20 is coupled to the micro-ring filtering assembly 30, and the micro-ring filtering assembly 30 is further coupled to the reflection assembly 40.

Wherein:
The optical amplifier 10 is configured to gain amplify the optical signal to output a gain optical signal. It is worth mentioning that there is no limitation to the number of optical amplifiers 10. For example, in some embodiments, the number of the optical amplifiers 10 is two, and the gain wavelength ranges (i.e., operation wavelength ranges) of the two optical amplifiers 10 are adjacent to each other.

The channel selection assembly 20 is configured to select any optical amplifier 10 to input the gain optical signal to the micro-ring filtering assembly 30. Specifically, the channel selection assembly 20 selects one of the optical amplifiers 10 to couple with the micro-ring filtering assembly 30, and each optical amplifier 10 may input gain optical signals to the micro-ring filtering assembly 30 within its operation wavelength range. Through the alternate selection of the plurality of optical amplifiers 10 by the channel selection assembly 20, the laser may be adjusted in different wavelength ranges. For example, in some embodiments, the number of optical amplifier 10 is two. When the channel selection assembly 20 controls one of the optical amplifiers 10 to couple with the micro-ring filtering assembly 30, it may be understood that the selected optical amplifier 10 is in the "on" state at this time, and the selected optical amplifier 10 should be injected with current to generate a gain optical signal within its operation wavelength range, while the other unselected optical amplifier 10 is in an "off" state, and the selected optical amplifier 10 has no current injection and thus no gain optical signal is generated. In addition, since the operation wavelength ranges of the two optical amplifiers 10 are adjacent to each other, through the configuration of the channel selection assembly 20, laser tuning may be achieved within a large, continuous gain wavelength range, thus effectively expanding the wavelength range for laser tuning of the tunable laser 100.

The micro-ring filtering assembly 30 is configured to filter the gain optical signal under the vernier caliper effect to obtain the filtered optical signal, and then inputs the filtered optical signal into the reflection assembly 40. Specifically, in some embodiments, the number of the optical amplifier 10 is two, and the channel selection assembly 20 selects to open one of the optical amplifiers 10. Under the circumstances, the micro-ring filtering assembly 30 may perform filtering within the operation wavelength range of the selected optical amplifier 10, which is equivalent to the micro-ring filtering assembly 30 being equivalent to the chip, which is equivalent to a reflector with wavelength selectivity. The gain optical signal within the operation wavelength range of the selected optical amplifier 10 is input to the reflection assembly 40, and the optical signal outside the operation wavelength range of the selected optical amplifier 10 is filtered, thereby achieving filtering processing of the gain optical signal.

The reflection assembly 40 is configured to use a part of the optical signal in the filtered optical signal as an output optical signal for outputting outward, and reflect, after the remaining optical signal passes through the micro-ring filtering assembly 30, the remaining optical signal to the optical amplifier 10 currently selected by the channel selection assembly 20. That is, the part of the optical signal is returned to the optical amplifier 10 along the original path as a reflected optical signal. The reflection assembly 40 and the optical amplifier 10 together form a laser resonant cavity, thereby achieving tuning of the laser. Specifically, in some embodiments, the number of the optical amplifier 10 is two, and each optical amplifier 10 and the reflection assembly 40 form a laser resonant cavity. Here, it is equivalent to two laser resonant cavities sharing one reflection assembly 40. The reflection directions of the two laser resonant cavities in the reflection assembly 40 are opposite to each other.

In the above-mentioned tunable laser 100, the plurality of optical amplifiers 10 respectively correspond to different operation wavelength ranges. Through the channel selection assembly 20, the plurality of optical amplifiers 10 may be used alternately to achieve laser tuning within a large and continuous gain wavelength range, thus effectively expanding the wavelength range for laser tuning of the tunable laser 100.

It should be noted that there is no limitation to the structural form of the channel selection assembly 20. To facilitate understanding, the following description will be carried out with reference to different drawings, but the structural form of the channel selection assembly 20 is not limited thereto, specifically as follows.

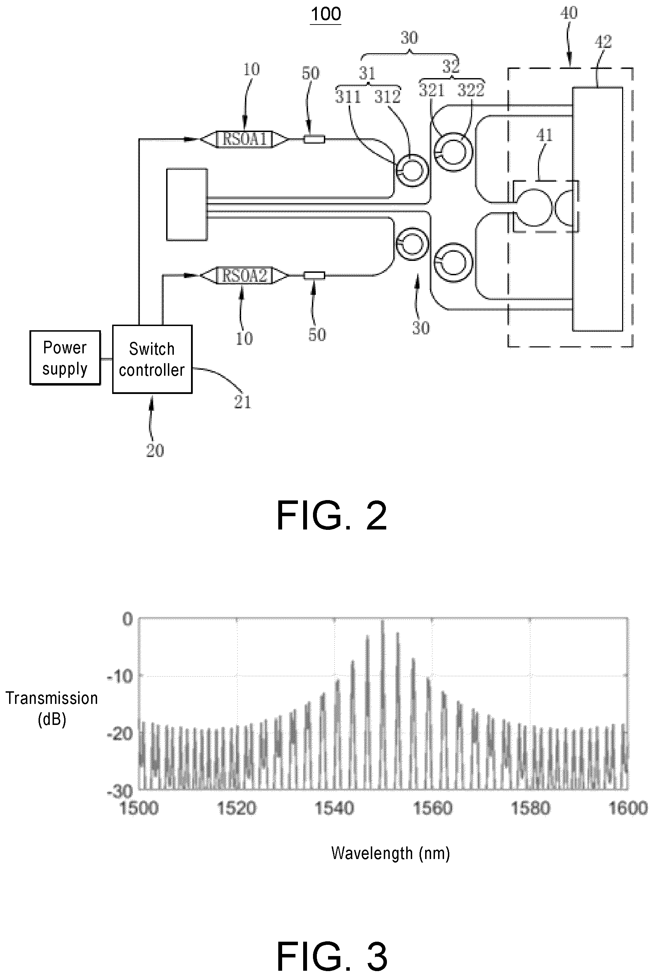

As shown in FIG. 2, in some embodiments, the channel selection assembly 20 includes a switch controller 21, and the switch controllers 21 are respectively connected to the plurality of optical amplifiers 10. The number of the micro-ring filtering assembly 30 is multiple, and the plurality of micro-ring filtering assemblies 30 are coupled with the reflection assembly 40 through optical waveguide. The plurality of optical amplifiers 10 are respectively coupled to the plurality of micro-ring filtering assemblies 30 in one-to-one correspondence through optical waveguide.

The switch controller 21 is configured to control the conduction of any optical amplifier 10 and input a driving electrical signal to the conducted optical amplifier 10. Specifically, the input terminal of the switch controller 21 is connected to the power supply, and the output terminal of the switch controller 21 is electrically connected to the plurality of optical amplifiers 10 respectively. For example, in some embodiments, the power supply is a DC power supply, and the output terminal of the switch controller 21 is connected to the optical amplifier RSOA1 and the optical amplifier RSOA2 respectively. The switch controller 21 is configured to control the optical amplifier RSOA1 or the optical amplifier RSOA2 to turn on or off. When the switch controller 21 controls the optical amplifier RSOA1 to turn on, and at the same time controls the optical amplifier RSOA2 to turn off, the driving electrical signal of the power supply is input to RSOA1 to input driving electrical signal through the switch controller 21; conversely, when the switch controller 21 controls the optical amplifier RSOA2 to turn on, the process proceeds analogously. For the sake of brevity, the detailed explanation of this scenario will not be reiterated herein.

The optical amplifier 10 is configured to output a gain optical signal to the micro-ring filtering assembly 30 correspondingly coupled thereto under the drive of the driving electrical signal. Specifically, in some embodiments, when being turned on, the optical amplifier RSOA1 outputs a gain optical signal to the micro-ring filtering assembly 30 correspondingly coupled to the optical amplifier RSOA1 in the first operation wavelength range under the drive of the driving electrical signal. When being turned on, the optical amplifier RSOA2 outputs a gain optical signal to the micro-ring filtering assembly 30 correspondingly coupled to the optical amplifier RSOA2 in the second operation wavelength range under the drive of the driving electrical signal.

In the above embodiment, through the setting of the switch controller 21, the on and off control of the plurality of optical amplifiers 10 may be realized, thereby avoiding the phenomenon of optical signal interference caused by different optical amplifiers 10 outputting gain signals at the same time, which helps to enhance the stability of the optical scanning signal ultimately output outward by the tunable laser 100.

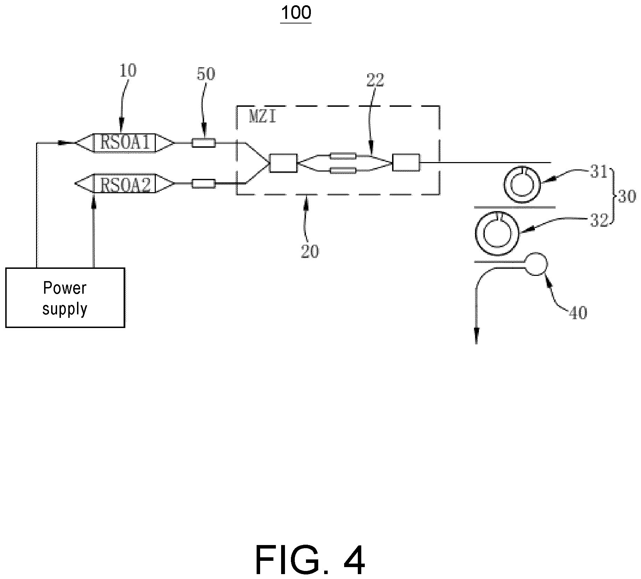

As shown in FIG. 4, in some embodiments, the channel selection assembly 20 includes a first optical switch 22. The first optical switch 22 includes two first input terminals and a first output terminal. The two first input terminals of the first optical switch 22 are connected to the two optical amplifiers 10 respectively, and the first output terminal is connected to the micro-ring filtering assembly 30.

The first optical switch 22 is configured to control one of the optical amplifiers 10 to input a gain optical signal to the micro-ring filtering assembly 30.

Specifically, in some embodiments, the first optical switch 22 is an optical switch composed of a Mach-Zehnder interferometer (MZI), and the two first input terminals of the first optical switch 22 are coupled to the optical amplifier RSOA1 and the optical amplifier RSOA2 respectively. When the first input terminal connected to the optical amplifier RSOA1 is controlled to be turned on by the first optical switch 22, the gain optical signal of the optical amplifier RSOA1 is input to the micro-ring filtering assembly 30 through the first output terminal of the first optical switch 22; when the first input terminal connected to the optical amplifier RSOA2 is turned on, the gain optical signal of the optical amplifier RSOA2 is input to the micro-ring filtering assembly 30 through the first output terminal of the first optical switch 22.

In the above embodiment, through the arrangement of the first optical switch 22, the plurality of optical amplifiers 10 may share a micro-ring filtering assembly 30, so it is possible to better simplify the structure of the tunable laser 100.

As shown in FIG. 2, in some embodiments, the tunable laser 100 further includes a first phase shifter 50. The first phase shifter 50 is connected to the optical amplifier 10 and coupled to the micro-ring filtering assembly 30. Each optical amplifier 10 includes a semiconductor optical amplifier (RSOA, full name: Reflective Semiconductor Optical Amplifier) with a high-reflectivity surface. wherein:
The reflection assembly 40 is a circular reflector, which is configured to reflect a part of optical signal in the filtered optical signal to the high-reflectivity surface of the semiconductor optical amplifier after the part of the optical signal passes through the micro-ring filtering assembly 30. The reflection assembly 40 and the semiconductor optical amplifier together form a characteristic resonant cavity.

The first phase shifter 50 is configured to adjust the resonant wavelength of the characteristic resonant cavity to be the same as the resonant wavelength of the micro-ring filtering assembly 30, such that the optical signal reflected back from the reflection assembly 40 may be incident on the high-reflectivity surface of the semiconductor optical amplifier through the first phase shifter 50. Specifically, the first phase shifter 50 includes but is not limited to one of a phase shifter composed of an SOI silicon-based optical waveguide and a PIN junction diode and a phase shifter composed of an SOI silicon-based optical waveguide and a metal heater. The first phase shifter 50 is configured to perform phase modulation using the electro-optical effect of a PIN junction diode, or perform phase modulation using a metal electrode thermal adjustment method to achieve high-speed phase modulation. The phase modulation speed may reach GHz (gigahertz, or GHz) level, which helps to improve the spectral scanning efficiency of the tunable laser 100.

Further, in some embodiments, the micro-ring filtering assembly 30 includes a first micro-ring 311 resonant cavity 31 and a second micro-ring 321 resonant cavity 32. The first micro-ring 311 resonant cavity 31 and the second micro-ring 321 resonant cavity 32 have different dimensions and the same resonant wavelength.

Specifically, the first micro-ring 311 resonant cavity 31 is coupled with the semiconductor optical amplifier, and the first micro-ring 311 resonant cavity 31 and the second micro-ring 321 resonant cavity 32 are coupled together to form a cascaded micro-ring structure, and the second micro-ring 321 resonant cavity 32 is further coupled to the reflection assembly 40.

The first micro-ring 311 resonant cavity 31 and the second micro-ring 321 resonant cavity 32 jointly produce a vernier caliper effect to filter the gain optical signal.

The first phase shifter 50 is configured to adjust the resonant wavelength of the characteristic resonant cavity to be the same as the resonant wavelength of the first micro-ring 311 resonant cavity 31 and the second micro-ring 321 resonant cavity 32, so that the optical signal reflected back from the reflection assembly 40 may be incident on the high-reflectivity surface of the semiconductor optical amplifier through the first phase shifter 50.

In order to further understand the working principle of the micro-ring filtering assembly 30, more specifically, in some embodiments, the first micro-ring 311 resonant cavity 31 includes a first micro-ring 311 and a second phase shifter 312 connected to the first micro-ring 311. The second micro-ring 321 resonant cavity 32 includes a second micro-ring 321 and a third phase shifter 322 connected to the second micro-ring 321. The first micro-ring 311 and the second micro-ring 321 have different dimensions. The first micro-ring 311 and the second micro-ring 321 together form a cascaded micro-ring structure, and the cascaded micro-ring structure is able to produce a vernier caliper effect.

The second phase shifter 312 is configured to adjust the resonant wavelength of the first micro-ring 311; the third phase shifter 322 is configured to adjust the resonant wavelength of the second micro-ring 321 to be the same as the resonant wavelength of the first micro-ring 311. It is worth mentioning that the structural form and working principle of the second and third phase shifters 322 are the same as the structural form and working principle of the first phase shifter 50, and will not be described in detail here.

Please also refer to FIG 3. FIG. 3 shows the reflection spectrum of the optical amplifier 10 by the cascaded micro-ring structure (i.e., the first micro-ring 311 resonant cavity 31 and the second micro-ring 321 resonant cavity 32) under the vernier caliper effect. It may be seen that within the bandwidth range of 100nm, there is only one highest resonance peak. The first phase shifter 50 between the optical amplifier 10 (RSOA1 or RSOA2) and reflection assembly 40 is adjusted, so that the longitudinal mode of the characteristic resonant cavity composed of the optical amplifier 10 and the reflection assembly 40 coincides with the resonant peak, thereby achieving efficient output of single-wavelength laser. By adjusting the second phase shifter 312 of the first micro-ring 311 resonant cavity 31 and the third phase shifter 322 on the second micro-ring 321 resonant cavity 32, it is possible to make the resonant wavelengths of the first micro-ring and second micro-ring drift, so as to make the resonant wavelengths of the first micro-ring and the second micro-ring to be consistent. Through the vernier caliper effect, it is possible for the resonant peak of the cascaded micro-ring structure to be tuned within the entire bandwidth range to achieve a large free spectral range.

In the above structure, by simultaneously adjusting the first, second and third phase shifters, it is possible to achieve continuous wavelength tuning in the entire wavelength band.

In some embodiments, the reflection assembly 40 includes a mutually coupled optical reflector 41 and a first optical coupler 42, the optical reflector 41 is coupled to the micro-ring filtering assembly 30, the first optical coupler 42 includes a second output terminal and a third output terminal. The first optical coupler 42 is coupled to the micro-ring filtering assembly 30.

The optical reflector 41 is configured to input the filtered optical signal to the first optical coupler 42.

The first optical coupler 42 is configured to output a part of optical signal in the filtered optical signal outward through the second output terminal, and reflect the remaining optical signal in the filtered optical signal into the micro-ring filtering assembly 30 through the third output terminal.

Further, in some embodiments, each optical amplifier 10 includes a semiconductor optical amplifier with a high-reflectivity surface, and the reflection assembly 40 and the high-reflectivity surface of the semiconductor optical amplifier together form a characteristic resonant cavity.

The coupling coefficient of the first optical coupler 42 is a predetermined proportional threshold; wherein said proportional threshold is established in correlation with the loss of the characteristic resonant cavity and the intensity of reflected light from the characteristic resonant cavity on the semiconductor optical amplifier. Specifically, in this embodiment, the first optical coupler 42 is a coupler with a fixed coupling coefficient. That is, when designing the tunable laser 100, the coupling coefficient of the first optical coupler 42 is set to a proportional threshold in advance, and the above proportional threshold is determined by the loss of the characteristic resonant cavity and the intensity of reflected light from the characteristic resonant cavity on the semiconductor optical amplifier altogether. Here, the light intensity of the optical signal reflected back from the reflection assembly 40 into the characteristic resonant cavity needs to be greater than the loss of the entire characteristic resonant cavity, and greater than the intensity of reflected light from the characteristic resonant cavity on the semiconductor optical amplifier, thereby achieving the effect of enhancing the side mode suppression ratio.

Further, in some embodiments, the first optical coupler 42 includes a second optical switch with two adjustment arms.

The second optical switch is configured to adjust the coupling coefficient of the first optical coupler 42 by adjusting the light splitting ratio of the two adjustment arms. Specifically, a phase shifter may be disposed in the second optical switch, and the phase shifter may adjust the light splitting ratio of the two adjustment arms. For example, the phase shifter adjusts the light splitting ratio of the two adjustment arms by heating. In this embodiment, the first optical coupler 42 is a coupler with an adjustable coupling coefficient. By adjusting the coupling coefficient of the first optical coupler 42, the loss and gain of the entire characteristic resonant cavity may be balanced, and the light extraction efficiency of the tunable laser 100 may be improved as much as possible.

It is worth mentioning that the integration method of tunable laser includes but is not limited to one of heterogeneous integration or hybrid integration.

For example, when the channel selection assembly includes a switch controller, in some embodiments, the integration method of the tunable laser is heterogeneous integration, where the micro-ring filtering assembly and the reflection assembly are jointly integrated on the same silicon photonic chip, and the switch controller is arranged outside the silicon photonic chip. In other embodiments, the integration method of the tunable laser is hybrid integration, where the micro-ring filtering assembly, the reflection assembly and the switch controller are integrated on the same silicon photonic chip. Here, the optical amplifier is set outside the silicon photonic chip. This heterogeneous integration adopts longitudinal evanescent wave coupling, which requires an edge coupler to be disposed between the optical amplifier and the micro-ring filtering assembly to achieve the coupling between the two. The high degree of integration does not generate reflection on the gain medium of the optical amplifier, which is conducive to ensuring the optical intensity of the light signal reflected back to the characteristic resonant cavity.

For example, when the channel selection assembly includes the first optical switch, in some embodiments, the integration method of the tunable laser is heterogeneous integration, in which the micro-ring filtering assembly, the reflection assembly and the first optical switch are integrated into the same silicon photonic chip. In other embodiments, the integration method of the tunable laser is hybrid integration, in which the micro-ring filtering assembly, the reflection assembly and the first optical switch are jointly integrated on the same silicon photonic chip. Here, the optical amplifier is disposed outside the silicon photonic chip.

It may be understood that there is no limitation to the structural form of the optical waveguide in the above embodiments. The optical waveguide includes but is not limited to at least one of SOI silicon-based optical waveguide, SiN silicon-based optical waveguide and lithium niobate optical waveguide.

The present disclosure further provides an optical semiconductor element (not shown), and the above-mentioned tunable laser is integrated on the optical semiconductor element as above, such arrangement is conducive to improving the integration of the optical semiconductor element.

The technical features of the above embodiments may be combined in any way. To simplify the description, not all possible combinations of the technical features in the above embodiments are described. However, as long as there is no contradiction in the combination of these technical features, all possible combinations should be considered to be within the scope of the specification.

The above-described embodiments only express several embodiments of the present disclosure. The descriptions are relatively specific and detailed, but should not be construed as limiting the scope of the disclosure. It should be noted that, for those of ordinary skill in the art, several modifications and improvements can be made without departing from the concept of the present disclosure, and these all belong to the protection scope of the present disclosure. Therefore, the scope to be protected by the present disclosure should be determined by the appended claims.

## Claims

1. A tunable laser, **characterized in that** the tunable laser comprises a channel selection assembly, a plurality of optical amplifiers, a micro-ring filtering assembly and a reflection assembly, wherein the micro-ring filtering assembly is coupled to the reflection assembly, and operation wavelength ranges of the respective optical amplifiers are different, wherein:
the channel selection assembly is configured to select any of the optical amplifiers to input a gain optical signal to the micro-ring filtering assembly,
the micro-ring filtering assembly is configured to filter the gain optical signal under a vernier caliper effect to obtain a filtered optical signal and then input the filtered optical signal into the reflection assembly,
the reflection assembly is configured to output a part of optical signal in the filtered optical signal outward, and reflect, after remaining optical signals pass through the micro-ring filtering assembly, the remaining optical signals to an optical amplifier currently selected by the channel selection assembly.

2. The tunable laser according to claim 1, **characterized in that** the channel selection assembly comprises a switch controller, and the switch controller is respectively connected to the plurality of optical amplifiers, the number of the micro-ring filtering assembly is multiple, and the plurality of micro-ring filtering assemblies are respectively coupled to the plurality of optical amplifiers, wherein
the switch controller is configured to control conduction of any of the optical amplifiers and input a driving electrical signal to the conducted optical amplifier,
the optical amplifier is configured to output a gain optical signal to a micro-ring filtering assembly correspondingly coupled thereto under a drive of the driving electrical signal.

3. The tunable laser according to claim 1, **characterized in that** the channel selection
assembly comprises a first optical switch, the first optical switch comprises two first input terminals and a first output terminal, the two first input terminals of the first optical switch terminals are respectively connected to two of the optical amplifiers, and the first output terminal is connected to the micro-ring filtering assembly, wherein
the first optical switch is configured to control one of the optical amplifiers to input the gain optical signal to the micro-ring filtering assembly.

4. The tunable laser according claim 1, **characterized in that** the tunable laser further comprises a first phase shifter, the first phase shifter is connected to the optical amplifier and coupled to the micro-ring filtering assembly, each of the optical amplifiers comprises a semiconductor optical amplifier with a high-reflectivity surface, wherein
the reflection assembly is configured to reflect the part of optical signal in the filtered optical signal to the high-reflectivity surface of the semiconductor optical amplifier through the micro-ring filtering assembly, and together with the semiconductor optical amplifier form a characteristic resonant cavity,
the first phase shifter is configured to adjust a resonant wavelength of the characteristic resonant cavity to be the same as a resonant wavelength of the micro-ring filter.

5. The tunable laser according to claim 4, **characterized in that** the micro-ring filtering assembly comprises a first micro-ring resonant cavity and a second micro-ring resonant cavity, and the first micro-ring resonant cavity and the second micro-ring resonant cavity have different dimensions and a same resonant wavelength, the first micro-ring resonant cavity is coupled to the semiconductor optical amplifier and the second micro-ring resonant cavity respectively, and the second micro-ring resonant cavity is coupled to the reflection assembly, wherein
the first micro-ring resonant cavity and the second micro-ring resonant cavity jointly produce a vernier caliper effect to filter the gain optical signal,
the first phase shifter is configured to adjust the resonant wavelength of the characteristic resonant cavity to be the same as resonant wavelengths of the first micro-ring resonant cavity and the second micro-ring resonant cavity.

6. The tunable laser according to claim 5, **characterized in that** the first micro-ring resonant cavity comprises a first micro-ring and a second phase shifter connected to the first micro-ring, the second micro-ring resonant cavity comprises a second micro-ring and a third phase shifter connected to the second micro-ring, and the first micro-ring and the second micro-ring having different dimensions, wherein
the second phase shifter is configured to adjust a resonant wavelength of the first micro-ring,
the third phase shifter is configured to adjust a resonant wavelength of the second micro-ring to be the same as the resonant wavelength of the first micro-ring.

7. The tunable laser according to claim 1, **characterized in that** the reflection assembly comprises a mutually coupled optical reflector and a first optical coupler, the optical reflector is coupled to the micro-ring filtering assembly, the first optical coupler comprises a second output terminal and a third output terminal, and the first optical coupler is coupled to the micro-ring filtering assembly, wherein
the optical reflector is configured to input the filtered optical signal to the first optical coupler,
the first optical coupler is configured to output the part of optical signal in the filtered optical signal outward through the second output terminal, and reflect the remaining optical signal in the filtered optical signal into the micro-ring filtering assembly through the third output terminal.

8. The tunable laser according to claim 7, **characterized in that** each of the optical amplifiers comprises a semiconductor optical amplifier with a high-reflectivity surface,
and the reflection assembly and the high-reflectivity surface of the semiconductor optical amplifier together form a characteristic resonant cavity,
a coupling coefficient of the first optical coupler is a predetermined proportional threshold, wherein the proportional threshold is established in correlation with a loss of the characteristic resonant cavity and an intensity of a reflected light from the characteristic resonant cavity on the semiconductor optical amplifier.

9. The tunable laser according to claim 7, **characterized in that** the first optical coupler comprises a second optical switch having two adjustment arms, wherein
the second optical switch is configured to adjust a coupling coefficient of the first optical coupler by adjusting a light splitting ratio of the two adjustment arms.

10. The tunable laser according to claim 1, **characterized in that** an integration method of the tunable laser comprises but is not limited to one of heterogeneous integration or hybrid integration.

11. An optical semiconductor element, **characterized in that** the tunable laser according to claim 1 is integrated on the optical semiconductor element.
